# EUROPEAN PATENT SPECIFICATION

(11) **EP 3 214 762 B1**
(45) Date of publication and mention of the grant of the patent: **12.08.2020**
(21) Application number: 17157518.6
(22) Date of filing: 23.02.2017
(51) Int. Cl.: H03K 17/955, H01H 25/04

(54) **INPUT APPARATUS**
EINGABEEINRICHTUNG
APPAREIL D'ENTRÉE

(30) Priority: 03.03.2016 JP 2016040965
(43) Date of publication of application: 06.09.2017
(73) Proprietor: Alps Alpine Co., Ltd., Tokyo 145-8501 (JP)
(72) Inventor: Sasaki, Takayuki, Tokyo, Tokyo 145-8501 (JP); Yamagata, Kazuyoshi, Tokyo, Tokyo 145-8501 (JP)
(74) Representative: Schmitt-Nilson Schraud Waibel Wohlfrom Patentanwälte Partnerschaft mbB

(56) References cited:
- DE-A1-102011 087 232
- US-A1- 2005 139 458
- US-A1- 2007 052 598
- US-A1- 2011 042 196

## Description

### BACKGROUND OF THE INVENTION

### 1. Field of the Invention

The present invention relates to an input apparatus including a switch that switches an input mode as a result of an operation knob being operated and an electrostatic capacitance sensor that detects an operating body, such as a finger, coming close to or being in contact with the operation knob.

### 2. Description of the Related Art

In the related art, an input apparatus disclosed in Japanese Unexamined Patent Application Publication No. 2015-15202 is known as an example of an input apparatus that includes an electrostatic capacitance sensor.

In the input apparatus, the electrostatic capacitance sensor is incorporated in an operation knob and detects a finger or the like coming close to or being in contact with the operation knob. The electrostatic capacitance sensor has a structure in which detected information is retrieved by using a flexible printed circuit board.

The input apparatus disclosed in Japanese Unexamined Patent Application Publication No. 2015-15202 uses a flexible printed circuit board in order to retrieve detected information obtained by the electrostatic capacitance sensor, and this results in an increase in the manufacturing costs of components.

In addition, there has been a problem in that the flexible printed circuit board has flexibility, which in turn results in poor assembling ability.

US 2007/052598 A1 discloses a presence detection control knob. The control knob comprises a mobile part capable of being actuated manually and linked with an electromechanical transducer. The knob also comprises a metal surface arranged in the vicinity of the mobile part and means to measure the capacitance of the metal surface so that the presence of a finger in the vicinity of the mobile part can be detected.

US 2011/042196 A1 discloses a push switch equipped with a capacitance sensor and an input apparatus including the same, the input apparatus being in accordance with the preamble of claim 1. The push switch includes an operating member, a holding member, a detecting electrode including a plate-shaped spring, a conductive coil spring, and a wiring substrate. The operating member includes a top portion. The rear surface of the top portion and the holding member define a storage space. The detecting electrode, received in the storage space, includes a detecting portion in resilient contact with the top portion, a base in resilient contact with the coil spring, and a height adjusting portion coupling the detecting portion to the base. The amount of compression of the detecting electrode is defined depending on the height of the storage space.

The present invention relates to an input apparatus in accordance with the appended claims.

### SUMMARY OF THE INVENTION

The present invention provides an input apparatus capable of reducing the manufacturing costs of components and having a favorable assembling ability.

In addition, the present invention provides an input apparatus capable of suppressing rattling of an operation knob with respect to a case and ensuring stable operation of the operation knob.

An input apparatus according to the present invention includes a switch that switches an input mode as a result of an operation knob, which is attached to a case, being operated and an electrostatic capacitance sensor that detects an operating body coming close to or being in contact with the operation knob. The electrostatic capacitance sensor includes an electrostatic-capacitance detection plate attached to a rear surface of the operation knob, the electrostatic-capacitance detection plate being made of a metal, a circuit board disposed in such a manner as to face the operation knob with a predetermined distance between the circuit board and the operation knob, an electrostatic capacitance detection circuit pattern formed on the circuit board, and a compression-coil spring having a first end, which is caused to abut against the electrostatic-capacitance detection plate by an urging force in such a manner as to be electrically connected to the electrostatic-capacitance detection plate, and a second end, which is caused to abut against the electrostatic capacitance detection circuit pattern by an urging force so as to be electrically connected to the electrostatic capacitance detection circuit pattern.

In this configuration, by only causing the first end of the compression-coil spring to abut against the electrostatic-capacitance detection plate and causing the second end of the compression-coil spring to abut against the electrostatic capacitance detection circuit pattern, the electrostatic-capacitance detection plate and the electrostatic capacitance detection circuit pattern may be electrically connected to each other.

Therefore, it is not necessary to use a flexible printed circuit board, which leads to high manufacturing costs of components, as in the related art, and the electrostatic capacitance sensor may be easily assembled.

In addition, since the first and second ends of the compression-coil spring are respectively caused to abut against the electrostatic-capacitance detection plate, which is attached to the rear surface of the operation knob, and the electrostatic capacitance detection circuit pattern, which is formed on the circuit board, such that the operation knob is constantly raised upward by the urging force of the compression-coil spring, rattling will not be generated between the operation knob and the case, and the operation knob may be operated so as to be inclined accurately. A spring support member is provided on a side on which the rear surface of the operation knob is present. A spring support hole into which the compression-coil spring is inserted is formed in the spring support member in such a manner as to extend through the spring support member. The spring support hole is formed such that a width of the spring support hole on an entry side from which the compression-coil spring is inserted is large, and the width of the spring support hole on an exit side from which the compression-coil spring is exited is small. A portion of the compression-coil spring on the first end side is supported in such a manner as to be capable of freely reciprocating on the exit side of the spring support hole.

With this configuration, an operation of inserting and fitting the compression-coil spring into the spring support hole may be easily performed. Consequently, by only mounting the operation knob onto the case 2 while the spring support member is attached to the operation knob, the compression-coil spring may be incorporated into the spring support member, and the first end of the compression-coil spring may be supported. Therefore, an operation of assembling the operation knob and the compression-coil spring may be easily performed.

In addition, since the width of the spring support hole on the exit side, on which the portion of the compression-coil spring on the first end side is supported, is small, positioning of the portion of the compression-coil spring on the first end side in a radial direction is performed with certainty, and the portion of the compression-coil spring on the first end side is stably supported in the spring support hole.

Preferably, the spring support hole of the spring support member is tapered such that the width of the spring support hole gradually decreases from the entry side, from which the compression-coil spring is inserted, toward the exit side, from which the compression-coil spring is exited.

In this configuration, even if the operation knob is inclined to a position where the inner peripheral surface of the spring support hole is in contact with the outer peripheral surface of the compression-coil spring, since the portion of the compression-coil spring on the first end side is supported in such a manner as to be capable of freely reciprocating on the exit side of the spring support hole, the compression-coil spring may be linearly supported. Therefore, the first end of the compression-coil spring may be made to constantly abut against the electrostatic capacitance detection plate by an urging force, and the contact state between the first end of the compression-coil spring and the electrostatic capacitance detection plate may be stable.

Preferably, at least a portion of the compression-coil spring on the first end side, which is supported by the spring support member, is closely wound.

In this configuration, since the portion of the compression-coil spring on the first end side, which is supported by the spring support member, is closely wound, the compression-coil spring may be easily supported, and a stably supported state of the compression-coil spring may be obtained. In addition, since at least the portion of the compression-coil spring on the first end side is closely wound, when transporting the compression-coil springs, the compression-coil springs are less likely to become tangled with one another, and an operation of picking up the compression-coil springs may be easily performed.

Preferably, the switch is a four-direction push switch attached to the case such that the operation knob is capable of being freely inclined in four directions, which are perpendicular to one another, and the first end of the compression-coil spring is supported by the spring support member in such a manner as to be caused to abut against the electrostatic-capacitance detection plate by an urging force and to be located at the center of inclination of the operation knob.

In this configuration, by causing the first end of the compression-coil spring to abut against a center portion of the electrostatic-capacitance detection plate by the urging force so as to be located at the center of inclination of the operation knob, when operating the operation knob such that the operation knob is inclined, a force is uniformly transferred to the operating body, such as a finger, and the operation knob may be smoothly operated so as to be inclined in any one of the four directions.

According to the present invention, an input apparatus capable of reducing the manufacturing costs of components and having a favorable assembling ability can be provided.

In addition, according to the present invention, an input apparatus capable of suppressing rattling of an operation knob with respect to a case and ensuring stable operation of the operation knob can be provided.

### BRIEF DESCRIPTION OF THE DRAWINGS

Fig. 1 is a perspective view of an input apparatus according to an embodiment of the present invention;
Fig. 2 is an enlarged cross-sectional view taken along line II-II of Fig. 1 schematically illustrating the input apparatus;
Fig. 3 is an exploded perspective view of the input apparatus;
Fig. 4 is an enlarged, exploded perspective view illustrating a four-direction push switch of the input apparatus;
Fig. 5 is an enlarged perspective view illustrating the internal structure of an operation knob of the input apparatus;
Fig. 6 is an enlarged perspective view of a spring support member of the input apparatus;
Fig. 7 is an enlarged perspective view of a portion of a case of the input apparatus on which the operation knob is to be mounted;
Fig. 8 is an enlarged perspective view of an electrostatic-capacitance detection plate of an electrostatic capacitance sensor of the input apparatus;
Fig. 9 is an enlarged cross-sectional view illustrating a portion of the input apparatus including the spring support member illustrated in Fig. 2;
Fig. 10 is an enlarged perspective view illustrating the electrostatic capacitance sensor of the input apparatus;
Fig. 11 is an enlarged cross-sectional view schematically illustrating the input apparatus illustrated in Fig. 2 in a state where the operation knob has been inclined;
Fig. 12 is an enlarged cross-sectional view of a portion including the spring support member illustrated in Fig. 11; and
Fig. 13 is an enlarged cross-sectional view taken along line XIII-XIII of Fig. 2 schematically illustrating the operation knob of the input apparatus in a state where the operation knob has been inclined.

### DESCRIPTION OF THE PREFERRED EMBODIMENTS

An input apparatus according to an embodiment of the present invention will be described below with reference to the drawings.

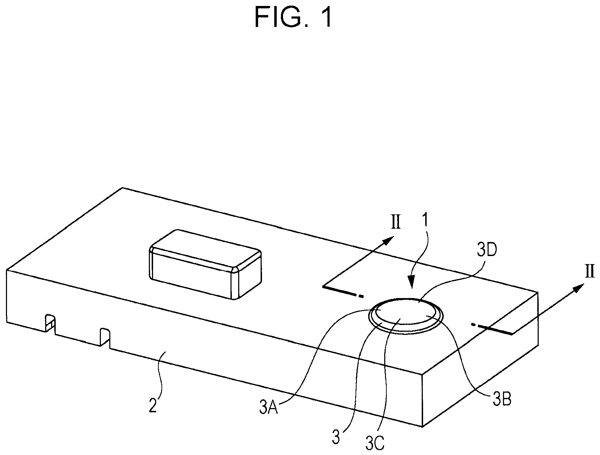

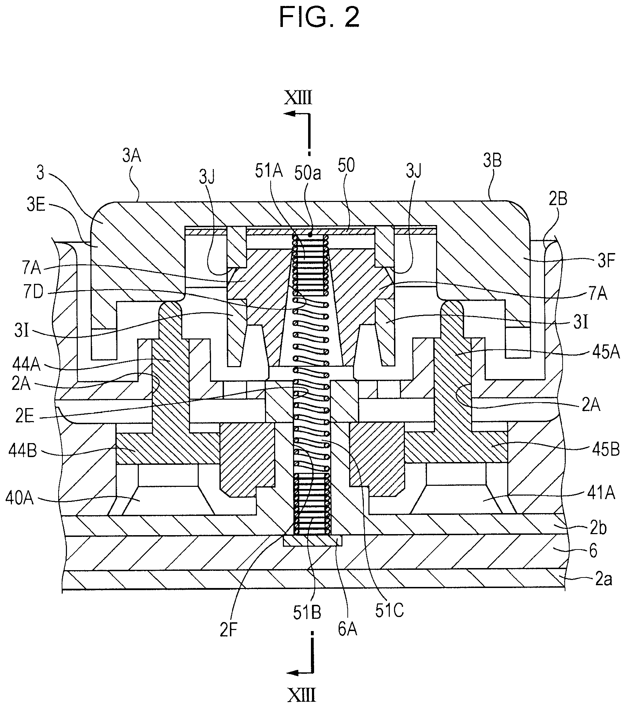

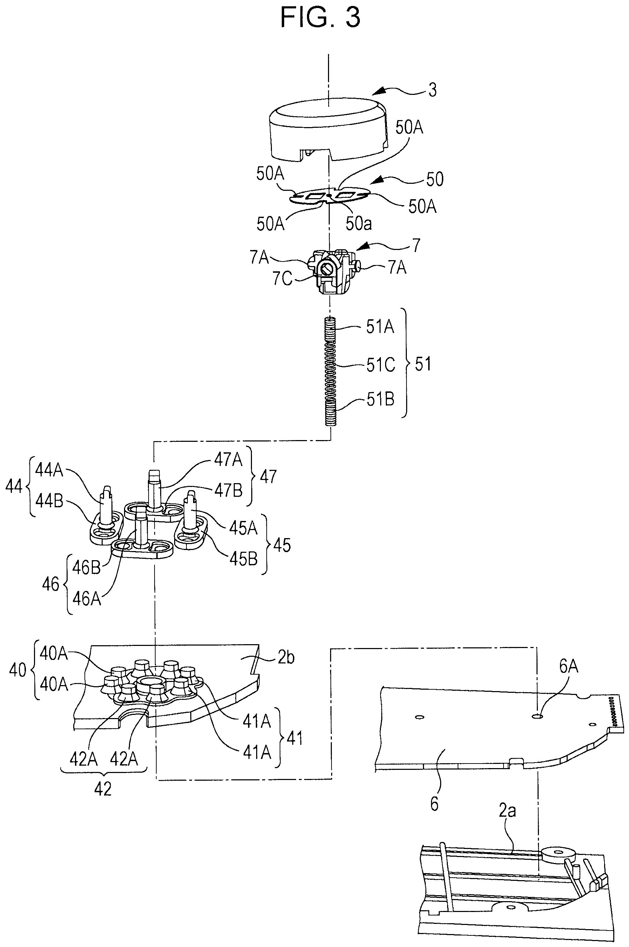

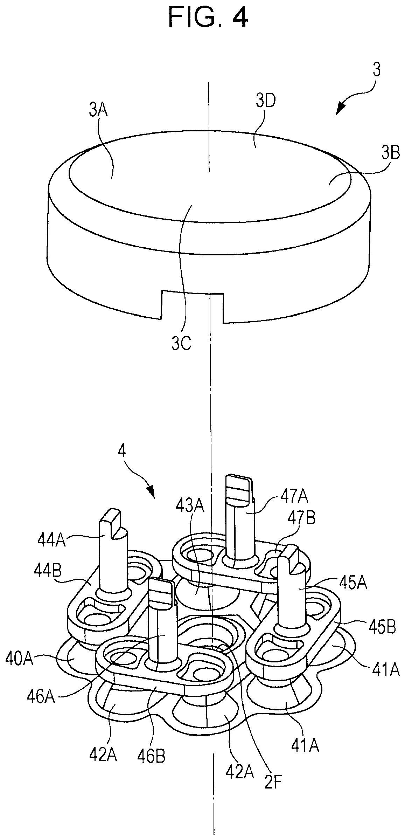

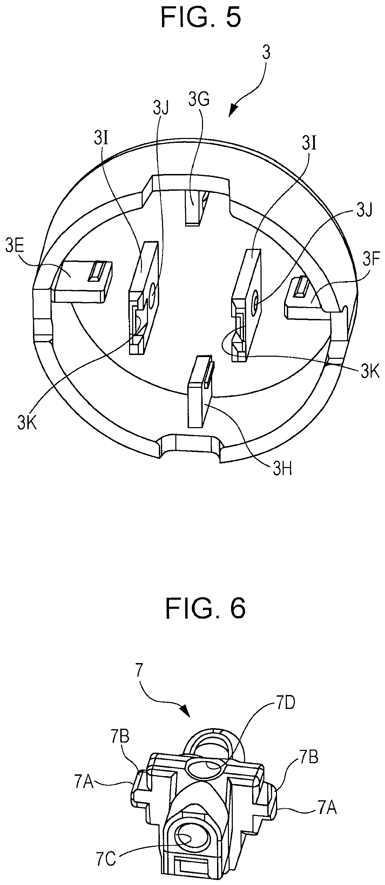

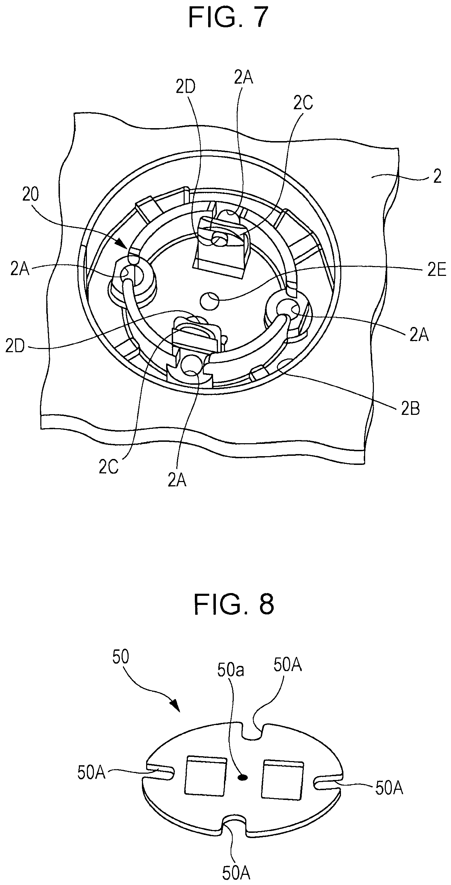

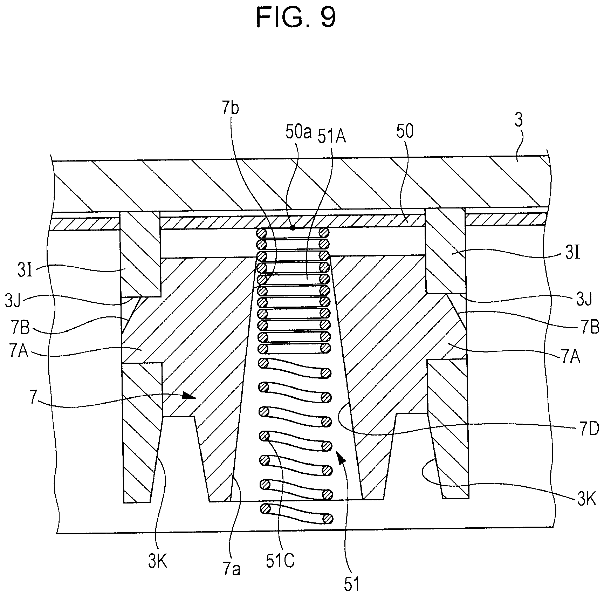

Fig. 1 is a perspective view of an input apparatus according to the present embodiment of the present invention. Fig. 2 is an enlarged cross-sectional view taken along line II-II of Fig. 1 schematically illustrating the input apparatus. Fig. 3 is an exploded perspective view of the input apparatus. Fig. 4 is an enlarged, exploded perspective view illustrating a four-direction push switch of the input apparatus. Fig. 5 is an enlarged perspective view illustrating the internal structure of an operation knob of the input apparatus. Fig. 6 is an enlarged perspective view of a spring support member of the input apparatus. Fig. 7 is an enlarged perspective view of a portion of a case of the input apparatus on which the operation knob is to be mounted. Fig. 8 is an enlarged perspective view of an electrostatic-capacitance detection plate of the input apparatus. Fig. 9 is an enlarged cross-sectional view illustrating a portion of the input apparatus including the spring support member illustrated in Fig. 2.

### (Input Apparatus)

An input apparatus 1 includes a four-direction push switch 4 serving as a switch that switches an input mode as a result of an operation knob 3, which is mounted on a case 2, being operated and an electrostatic capacitance sensor 5 that detects an operating body, such as a finger, coming close to or being in contact with the operation knob 3.

### (Four-Direction Push Switch)

The four-direction push switch 4 is a switch capable of switching input modes each corresponding to one of four directions, which are perpendicular to one another, as a result of the operation knob 3 being press-operated so as to be inclined in one of the four directions.

As illustrated in Fig. 4, the four-direction push switch 4 includes a first push switch portion 40, a second push switch portion 41, a third push switch portion 42, and a fourth push switch portion 43 that are mounted on a circuit board 6, which is disposed on a lower base 2a of the case 2, in such a manner as to be spaced apart from one another by 90 degrees. The four-direction push switch 4 further includes a first stem portion 44, a second stem portion 45, a third stem portion 46, and a fourth stem portion 47 each of which performs a pressing operation on a corresponding one of the push switch portions 40, 41, 42, and 43 as a result of the operation knob 3 being press-operated so as to be inclined.

The operation knob 3 is formed in a cylindrical shape having a small height. A first pressing portion 3A is formed in the top surface of the operation knob 3 and is used for driving the first push switch portion 40 by operating the operation knob 3 such that the operation knob 3 is inclined. A second pressing portion 3B is formed in the top surface of the operation knob 3 and is used for driving the second push switch portion 41 by operating the operation knob 3 such that the operation knob 3 is inclined. A third pressing portion 3C is formed in the top surface of the operation knob 3 and is used for driving the third push switch portion 42 by operating the operation knob 3 such that the operation knob 3 is inclined. A fourth pressing portion 3D is formed in the top surface of the operation knob 3 and is used for driving the fourth push switch portion 43 by operating the operation knob 3 such that the operation knob 3 is inclined.

The first push switch portion 40 includes a pair of first rubber switch portions 40A and 40A each of which is formed on a portion of a protective cover 2b, which is disposed on the circuit board 6. Similarly, the second push switch portion 41 includes a pair of second rubber switch portions 41A and 41A each of which is formed on a portion of the protective cover 2b. The third push switch portion 42 includes a pair of third rubber switch portions 42A and 42A each of which is formed on a portion of the protective cover 2b. The fourth push switch portion 43 includes a pair of fourth rubber switch portions 43A and 43A each of which is formed on a portion of the protective cover 2b.

Each of the first rubber switch portions 40A is formed in a dome-like shape in such a manner as to elastically deform when a pressing operation is performed on the first pressing portion 3A of the operation knob 3. A moving contact (not illustrated) is provided on the inner top surface of a main body of the first rubber switch portion 40A, which is formed in a dome-like shape. When a pressing operation is performed on the operation knob 3, the main body of the first rubber switch portion 40A, which is formed in a dome-like shape, is recessed as a result of receiving a pressing force from the operation knob 3, and the moving contact is brought into contact with a stationary contact, which is provided on the circuit board 6. As a result, the first rubber switch portion 40A is brought into an ON state. When application of a pressing force to the first pressing portion 3A is stopped, the main body of the first rubber switch portion 40A returns to its original dome-like shape by using its elastic energy, and the moving contact is separated from the stationary contact. As a result, the first rubber switch portion 40A is brought into an OFF state.

Each of the second rubber switch portions 41A is formed in a dome-like shape in such a manner as to elastically deform when a pressing operation is performed on the second pressing portion 3B of the operation knob 3. A moving contact (not illustrated) is provided on the inner top surface of a main body of the second rubber switch portion 41A, which is formed in a dome-like shape. When a pressing operation is performed on the operation knob 3, the main body of the second rubber switch portion 41A, which is formed in a dome-like shape, is recessed as a result of receiving a pressing force from the operation knob 3, and the moving contact is brought into contact with a stationary contact, which is provided on the circuit board 6. As a result, the second rubber switch portion 41A is brought into the ON state. When application of a pressing force to the second pressing portion 3B is stopped, the main body of the second rubber switch portion 41A returns to its original dome-like shape by using its elastic energy, and the moving contact is separated from the stationary contact. As a result, the second rubber switch portion 41A is brought into the OFF state.

Each of the third rubber switch portions 42A is formed in a dome-like shape in such a manner as to elastically deform when a pressing operation is performed on the third pressing portion 3C of the operation knob 3. A moving contact (not illustrated) is provided on the inner top surface of a main body of the third rubber switch portion 42A, which is formed in a dome-like shape. When a pressing operation is performed on the operation knob 3, the main body of the third rubber switch portion 42A, which is formed in a dome-like shape, is recessed as a result of receiving a pressing force from the operation knob 3, and the moving contact is brought into contact with a stationary contact, which is provided on the circuit board 6. As a result, the third rubber switch portion 42A is brought into the ON state. When application of a pressing force to the third pressing portion 3C is stopped, the main body of the third rubber switch portion 42A returns to its original dome-like shape by using its elastic energy, and the moving contact is separated from the stationary contact. As a result, the third rubber switch portion 42A is brought into the OFF state.

Each of the fourth rubber switch portions 43A is formed in a dome-like shape in such a manner as to elastically deform when a pressing operation is performed on the fourth pressing portion 3D of the operation knob 3. A moving contact (not illustrated) is provided on the inner top surface of a main body of the fourth rubber switch portion 43A, which is formed in a dome-like shape. When a pressing operation is performed on the operation knob 3, the main body of the fourth rubber switch portion 43A, which is formed in a dome-like shape, is recessed as a result of receiving a pressing force from the operation knob 3, and the moving contact is brought into contact with a stationary contact, which is provided on the circuit board 6. As a result, the fourth rubber switch portion 43A is brought into the ON state. When application of a pressing force to the fourth pressing portion 3D is stopped, the main body of the fourth rubber switch portion 43A returns to its original dome-like shape by using its elastic energy, and the moving contact is separated from the stationary contact. As a result, the fourth rubber switch portion 43A is brought into the OFF state.

The first stem portion 44 includes a stem main body 44A and a first pressing piece portion 44B, which is formed on the lower end of the stem main body 44A and which is used for pressing the pair of first rubber switch portions 40A and 40A, and is substantially T-shaped. The stem main body 44A is supported by a stem support hole 2A, which is formed in such a manner as to extend through a bottom portion of an operation-knob accommodating portion 20 (described later), so as to be capable of freely reciprocating in the vertical direction with respect to the circuit board 6.

The second stem portion 45 includes a stem main body 45A and a second pressing piece portion 45B, which is formed on the lower end of the stem main body 45A and which is used for pressing the pair of second rubber switch portions 41A and 41A, and is substantially T-shaped. The stem main body 45A is supported by another stem support hole 2A, which is formed in such a manner as to extend through the bottom portion of the operation-knob accommodating portion 20, so as to be capable of freely reciprocating in the vertical direction with respect to the circuit board 6.

The third stem portion 46 includes a stem main body 46A and a third pressing piece portion 46B, which is formed on the lower end of the stem main body 46A and which is used for pressing the pair of third rubber switch portions 42A and 42A, and is substantially T-shaped. The stem main body 46A is supported by another stem support hole 2A, which is formed in such a manner as to extend through the bottom portion of the operation-knob accommodating portion 20, so as to be capable of freely reciprocating in the vertical direction with respect to the circuit board 6.

The fourth stem portion 47 includes a stem main body 47A and a fourth pressing piece portion 47B, which is formed on the lower end of the stem main body 47A and which is used for pressing the pair of fourth rubber switch portions 43A and 43A, and is substantially T-shaped. The stem main body 47A is supported by another stem support hole 2A, which is formed in such a manner as to extend through the bottom portion of the operation-knob accommodating portion 20, so as to be capable of freely reciprocating in the vertical direction with respect to the circuit board 6.

As illustrated in Fig. 5, a first pressing projection piece 3E is formed on the rear surface of the operation knob 3 in such a manner as to vertically extend therefrom and presses the stem main body 44A of the first stem portion 44 in a direction toward the circuit board 6 by being brought into contact with an end of the stem main body 44A. The end of the stem main body 44A is tapered, and when the operation knob 3 is operated so as to be inclined, the first pressing projection piece 3E of the operation knob 3 is smoothly brought into contact with the end of the stem main body 44A, so that the operation knob 3 can be smoothly operated.

A second pressing projection piece 3F is formed on the rear surface of the operation knob 3 in such a manner as to vertically extend therefrom and presses the stem main body 45A of the second stem portion 45 in the direction toward the circuit board 6 by being brought into contact with an end of the stem main body 45A. The end of the stem main body 45A is tapered, and when the operation knob 3 is operated so as to be inclined, the second pressing projection piece 3F of the operation knob 3 is smoothly brought into contact with the end of the stem main body 45A, so that the operation knob 3 can be smoothly operated.

A third pressing projection piece 3G is formed on the rear surface of the operation knob 3 in such a manner as to vertically extend therefrom and presses the stem main body 46A of the third stem portion 46 in the direction toward the circuit board 6 by being brought into contact with an end of the stem main body 46A. The end of the stem main body 46A is tapered, and when the operation knob 3 is operated so as to be inclined, the third pressing projection piece 3G of the operation knob 3 is smoothly brought into contact with the end of the stem main body 46A, so that the operation knob 3 can be smoothly operated.

A fourth pressing projection piece 3H is formed on the rear surface of the operation knob 3 in such a manner as to vertically extend therefrom and presses the stem main body 47A of the fourth stem portion 47 in the direction toward the circuit board 6 by being brought into contact with an end of the stem main body 47A. The end of the stem main body 47A is tapered, and when the operation knob 3 is operated so as to be inclined, the fourth pressing projection piece 3H of the operation knob 3 is smoothly brought into contact with the end of the stem main body 47A, so that the operation knob 3 can be smoothly operated.

As described above, as a result of selecting and pressing one of the four pressing portions 3A, 3B, 3C, and 3D of the operation knob 3 such that the operation knob 3 is operated so as to be inclined, the four-direction push switch 4 can select and cause to operate one of the push switch portions 40, 41, 42, and 43 and can perform a switching operation between the input modes corresponding to the four directions.

### (Spring Support Member)

As illustrated in Fig. 6, a spring support member 7 that supports a compression-coil spring 51 (hereinafter referred to as coil spring 51), which is included in the electrostatic capacitance sensor 5 (described later), is mounted on the rear surface of the operation knob 3.

As illustrated in Fig. 6, a pair of shaft portions 7A and 7A are each formed on one of two side portions of the spring support member 7, the two side portions opposing each other, in such a manner as to protrude therefrom. A pair of bearing pieces 31 and 31 each having elasticity are formed on the rear surface of the operation knob 3 in such a manner as to vertically extend therefrom and to face each other. The shaft portions 7A and 7A of the spring support member 7 are fitted into bearing holes 3J and 3J of the bearing pieces 31 and 31. The shaft portions 7A and 7A of the spring support member 7 are fitted into bearing holes 3J and 3J of the bearing pieces 31 and 31, and the spring support member 7 is attached to the operation knob 3 so as to be capable of freely swinging around the shaft portions 7A and 7A.

A top end portion of each of the shaft portions 7A and 7A of the spring support member 7 has an inclined surface 7B. An inner end portion of each of the bearing pieces 31 and 31 has an inclined surface 3K. Accordingly, when the shaft portions 7A and 7A of the spring support member 7 are fitted into the corresponding bearing holes 3J and 3J against an elastic force of the bearing pieces 31 and 31, the shaft portions 7A and 7A can be pressed while the inclined surfaces 7B, which are formed on the end portions of the shaft portions 7A and 7A, are moved along the corresponding inclined surfaces 3K of the bearing pieces 31 and 31, and the spring support member 7 can be smoothly attached to the operation knob 3.

A pair of bearing holes 7C and 7C are formed in two side portions of the spring support member 7, the two side portions being perpendicular to the centers of swing of the pair of shaft portions 7A and 7A, so as to face each other. Note that the pair of bearing holes 7C and 7C are formed in such a manner as to extend through the spring support member 7.

As illustrated in Fig. 7, the operation knob 3 is incorporated in the circular operation-knob accommodating portion 20 that has an opening 2B, which is formed in an upper portion of the case 2. A pair of support pieces 2C and 2C, each of which has elasticity and each of which is used for supporting the spring support member 7, are formed on the bottom portion of the operation-knob accommodating portion 20 in such a manner as to protrude therefrom and to face each other. A pair of shaft portions 2D and 2D are each formed on the inner side portion of a corresponding one of the pair of support pieces 2C and 2C in such a manner as as to protrude therefrom and to face each other. The shaft portions 2D and 2D are each fitted into a corresponding one of the bearing holes 7C and 7C of the spring support member 7, and the spring support member 7 is accommodated in the operation-knob accommodating portion 20 so as to be capable of freely swinging around the shaft portions 2D and 2D.

Accordingly, as a result of the shaft portions 2D and 2D formed on the support pieces 2C and 2C being fitted into the corresponding bearing holes 7C and 7C formed in the spring support member 7, the operation knob 3 is supported so as to be capable of being freely operated and inclined in two directions, and the operation knob 3 can selectively switch between a first input mode for pressing the first push switch portion 40 and a second input mode for pressing the second push switch portion 41.

In addition, as a result of the shaft portions 7A and 7A formed on the spring support member 7 being fitted into the corresponding bearing holes 3J and 3J of the bearing pieces 31 and 31 formed on the operation knob 3, the operation knob 3 is supported so as to be capable of being freely operated and inclined in two directions, and the operation knob 3 can selectively switch between a third input mode for pressing the third push switch portion 42 and a four input mode for pressing the fourth push switch portion 43.

### (Electrostatic Capacitance Sensor)

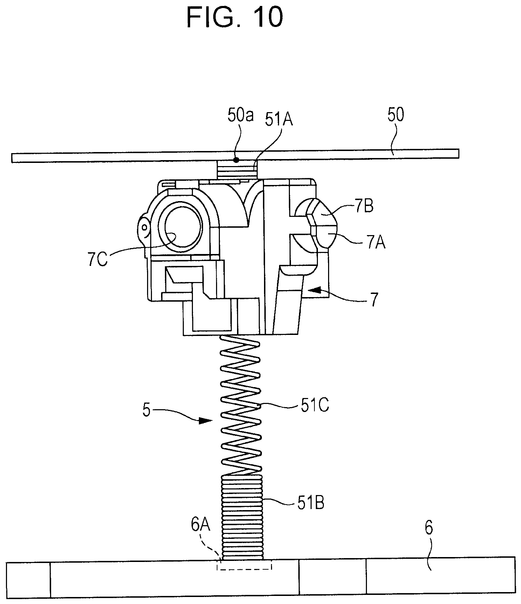

As illustrated in Fig. 10, the electrostatic capacitance sensor 5 includes an electrostatic-capacitance detection plate 50, which is provided on the rear surface of the operation knob 3 and which is made of a metal, an electrostatic capacitance detection circuit pattern 6A, which is formed on the circuit board 6, and the coil spring 51 having an upper end 51A, which is one of the two ends of the coil spring 51 and which is connected to the electrostatic-capacitance detection plate 50, and a lower end 51B, which is the other of the two ends of the coil spring 51 and which is electrically connected to electrostatic capacitance detection circuit pattern 6A.

When an operating body, such as a finger, comes close to or is in contact with the operation knob 3, that is, with the electrostatic-capacitance detection plate 50, the electrostatic capacitance formed between the operating body and the electrostatic-capacitance detection plate 50 changes. The change in the electrostatic capacitance can be detected by an electrostatic capacitance detection circuit (not illustrated), which is provided on the circuit board 6, via the coil spring 51, and thus, the operating body, such as a finger, coming close to or being in contact with the operation knob 3 is detected.

As illustrated in Fig. 8, cutout portions 50A, 50A, 50A, and 50A are formed in an outer peripheral portion of the electrostatic-capacitance detection plate 50 in such a manner as to be spaced apart from one another by 90 degrees in the circumferential direction of the electrostatic-capacitance detection plate 50 (see Fig. 5). As a result of the pressing projection pieces 3E, 3F, 3G, and 3H, which are formed on the rear surface of the operation knob 3, being fitted into the cutout portions 50A, 50A, 50A, and 50A, the electrostatic-capacitance detection plate 50 is positioned and fixed onto the rear surface of the operation knob 3.

As illustrated in Fig. 2, a portion of the coil spring 51 on the side of the upper end 51A is supported by the spring support member 7, which is attached to the operation knob 3. A spring support hole 7D is formed in the spring support member 7 in such a manner as to extend therethrough in the vertical direction. A lower opening 7a is formed at the lower end of the spring support hole 7D, and an upper opening 7b is formed at the upper end of the spring support hole 7D. The portion of the coil spring 51 on the side of the upper end 51A is supported in the upper opening 7b of the spring support hole 7D so as to be capable of freely reciprocating.

The coil spring 51 is inserted into the spring support hole 7D through the lower opening 7a such that the upper end 51A projects to the outside from the upper opening 7b. In addition, the upper end 51A is caused to abut against a plate surface of the electrostatic-capacitance detection plate 50 by an urging force so as to be electrically connected to the electrostatic-capacitance detection plate 50, and the lower end 51B is caused to abut against the electrostatic capacitance detection circuit pattern 6A of the circuit board 6 by an urging force so as to be electrically connected to electrostatic capacitance detection circuit pattern 6A.

Note that the coil spring 51 is inserted into a spring support hole 2E, which is formed in a center portion of a bottom portion of the operation-knob accommodating portion 20 in such a manner as to extend through the bottom portion, and an intermediate portion 51C of the coil spring 51 is supported by the spring support hole 2E. A portion of the coil spring 51 on the side of the lower end 51B is inserted into a support hole 2F, which is formed in the protective cover 2b, so as to be supported by the support hole 2F.

As described above, by only causing the upper end 51A of the coil spring 51 to abut against the electrostatic-capacitance detection plate 50 and causing the lower end 51B to abut against the electrostatic capacitance detection circuit pattern 6A, the electrostatic-capacitance detection plate 50 and electrostatic capacitance detection circuit pattern 6A can be electrically connected to each other. Therefore, it is not necessary to use a flexible printed circuit board, which leads to high manufacturing costs of components, as in the related art, and the electrostatic capacitance sensor 5 can be easily assembled.

Since the two ends 51A and 51B of the coil spring 51 are respectively caused to abut against the electrostatic-capacitance detection plate 50, which is attached to the rear surface of the operation knob 3, and the electrostatic capacitance detection circuit pattern 6A, which is formed on the circuit board 6, such that the operation knob 3 is constantly raised upward by an urging force of the coil spring 51, rattling will not be generated between the operation knob 3 and the case 2, and the operation knob 3 can be operated so as to be inclined accurately.

The upper end 51A of the coil spring 51 is caused to abut against a center portion 50a of the electrostatic-capacitance detection plate 50 by an urging force, and the center portion 50a corresponds to the center of inclination of the operation knob 3 in the four directions.

As described above, the upper end 51A of the coil spring 51 is caused to abut against the center portion 50a of the electrostatic-capacitance detection plate 50 by an urging force, and when operating the operation knob 3 such that the operation knob 3 is inclined, a force is uniformly transferred to the operating body, such as a finger, and the operation knob 3 can be smoothly operated so as to be inclined in any one of the four directions. In addition, when the operation knob 3 is operated so as to be inclined, the upper end 51A of the coil spring 51 can smoothly slide on the plate surface of the capacitance detection plate 50 by using the urging force of the coil spring 51, and the electrical contact state between the upper end 51A of the coil spring 51 and the capacitance detection plate 50 can be constantly stable.

In the spring support hole 7D, the lower opening 7a is formed so as to have a width larger than that of the upper opening 7b, and the spring support hole 7D is tapered such that the width of the spring support hole 7D gradually decreases from the lower opening 7a toward the upper opening 7b.

By tapering the spring support hole 7D in the manner described above, an operation of inserting and fitting the coil spring 51 into the spring support hole 7D may be easily performed. Accordingly, by only mounting the operation knob 3 onto the operation-knob accommodating portion 20 of the case 2 while the spring support member 7 is attached to the operation knob 3, the coil spring 51 can be incorporated into the spring support member 7, and the portion of the coil spring 51 on the side of the upper end 51A can be supported in the upper opening 7b of the spring support hole 7D. Therefore, the operation knob 3 and the coil spring 51 can be easily assembled together.

In addition, since the upper opening 7b of the spring support hole 7D of the spring support member 7 has a small width, positioning of the upper end 51A of the coil spring 51 in a radial direction is performed with certainty, and the portion of the coil spring 51 on the side of the upper end 51A is stably supported in the spring support hole 7D.

The portion of the coil spring 51 on the side of the upper end 51A and the portion of the coil spring 51 on the side of the lower end 51B are closely wound, and the intermediate portion 51C is sparsely wound. Since the portion of the coil spring 51 on the side of the upper end 51A, which is supported by the spring support member 7, is closely wound, the coil spring 51 can be easily supported, and a stably supported state of the coil spring 51 can be obtained. In addition, since the portion of the coil spring 51 on the side of the upper end 51A and the portion of the coil spring 51 on the side of the lower end 51B are closely wound, when transporting the coil springs 51, the coil springs 51 are less likely to become tangled with one another, and an operation of picking up the coil springs 51 may be easily performed.

The state of the operation knob 3 when the input mode is switched to the second input mode by operating the operation knob 3 such that the operation knob 3 is inclined will now be described in detail.

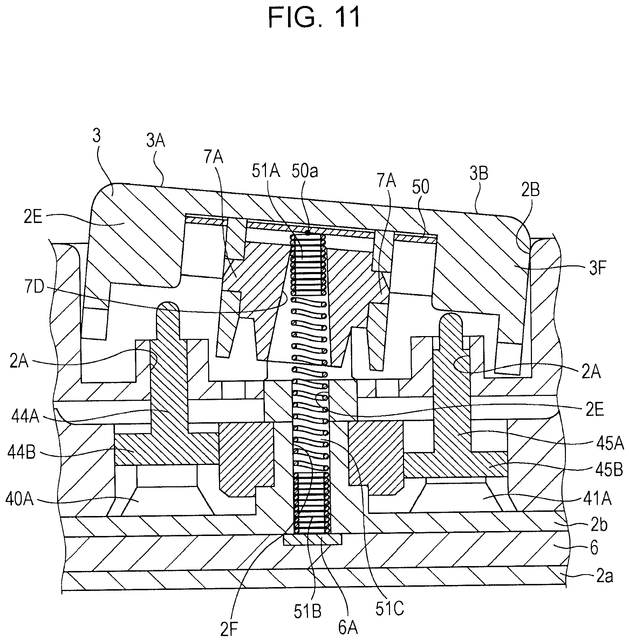

As illustrated in Fig. 11, when the second pressing portion 3B of the operation knob 3 is pressed, the operation knob 3 is inclined while the shaft portions 2D and 2D, which support the spring support member 7 such that the spring support member 7 is capable to freely swinging in the operation-knob accommodating portion 20, serve as the center of inclination of the operation knob 3. Then, the second pressing projection piece 3F, which is formed on the operation knob 3 in such a manner as to vertically extend therefrom, presses down the stem main body 45A of the second stem portion 45, and the second pressing piece portion 45B presses the pair of second rubber switch portions 41A and 41A. Then, the main body of the second rubber switch portions 41A, which is formed in a dome-like shape, is recessed, and the moving contact is brought into contact with the stationary contact, which is provided on the circuit board 6. As a result, the second rubber switch portions 41A is brought into the ON state.

Note that, when the operation knob 3 is operated so as to be inclined by pressing the second pressing portion 3B of the operation knob 3, the first pressing projection piece 3E, which is formed on the rear surface of the operation knob 3 in such a manner as to vertically extend therefrom, is separated from the end of the stem main body 44A of the first stem portion 44.

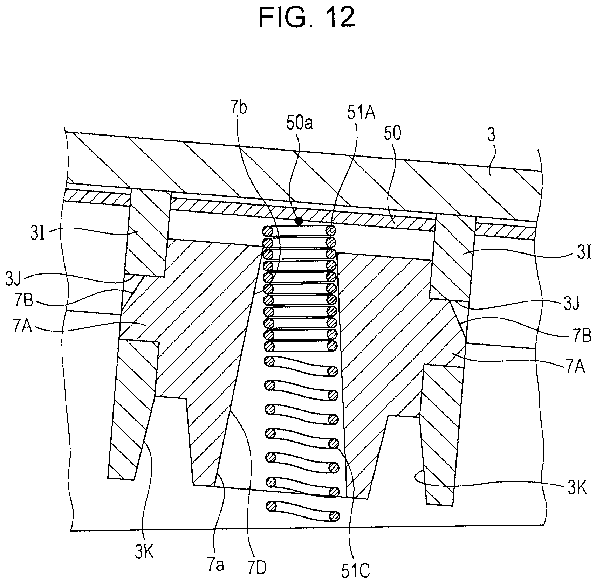

As described above, when the operation knob 3 is operated so as to be inclined, the spring support member 7 swings together with the operation knob 3 around the shaft portions 2D and 2D as illustrated in Fig. 12. In this case, since the spring support hole 7D is tapered, the coil spring 51 is inclined, while the portion of the coil spring 51 on the side of the upper end 51A is supported in the upper opening 7b of the spring support hole 7D, to a position where the inner peripheral surface of the spring support hole 7D is in contact with the outer peripheral surface of the coil spring 51. Thus, the coil spring 51 can be maintained in a state of being linearly supported, and the contact state between the upper end 51A of the coil spring 51 and the capacitance detection plate 50 may be stable. Note that the coil spring 51 is pressed down against the urging force thereof as a result of the operation knob 3 being operated so as to be inclined. However, since the portion of the coil spring 51 on the side of the upper end 51A is supported in the upper opening 7b of the spring support hole 7D of the spring support member 7 so as to be capable of freely reciprocating, the contact state between the upper end 51A of the coil spring 51 and the capacitance detection plate 50 can be maintained.

The state of the operation knob 3 when the input mode is switched to the third input mode by operating the operation knob 3 such that the operation knob 3 is inclined will now be described in detail.

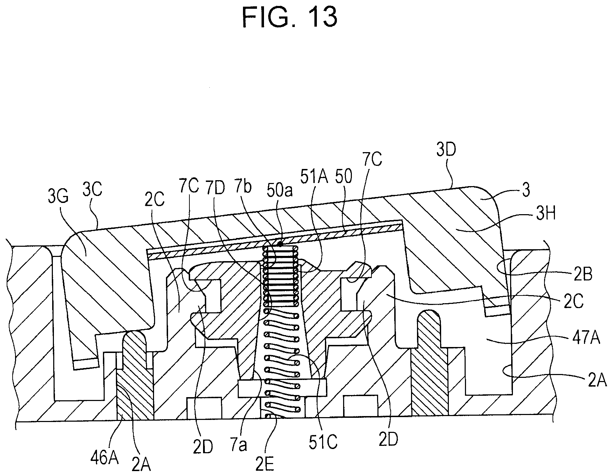

As illustrated in Fig. 13, when the third pressing portion 3C of the operation knob 3 is pressed, the operation knob 3 is inclined while the shaft portions 7A and 7A of the spring support member 7, which support the operation knob 3 such that the operation knob 3 is capable of freely swinging, serve as the center of inclination of the operation knob 3. Then, the third pressing projection piece 3G, which is formed on the operation knob 3 in such a manner as to vertically extend therefrom, presses down the stem main body 46A of the third stem portion 46, and the third pressing piece portion 46B presses the pair of third rubber switch portions 42A and 42A. Then, the main body of the third rubber switch portions 42A, which is formed in a dome-like shape, is recessed, and the moving contact is brought into contact with the stationary contact, which is provided on the circuit board 6. As a result, the third rubber switch portions 42A is brought into the ON state.

Note that, when the operation knob 3 is operated so as to be inclined by pressing the third pressing portion 3C of the operation knob 3, the fourth pressing projection piece 3H, which is formed on the rear surface of the operation knob 3 in such a manner as to vertically extend therefrom, is separated from the end of the stem main body 47A of the fourth stem portion 47.

As described above, when the operation knob 3 is operated so as to be inclined, the operation knob 3 swings around the shaft portions 7A and 7A, whereas the spring support member 7 does not swing. Thus, the coil spring 51 whose portion on the side of the upper end 51A is supported by the spring support member 7 can be maintained in a state of being linearly supported in the spring support hole 7D, and the contact state between the upper end 51A of the coil spring 51 and the capacitance detection plate 50 may be stable. Note that, also in this case, the coil spring 51 is pressed down against the urging force thereof as a result of the operation knob 3 being operated so as to be inclined. However, since the portion of the coil spring 51 on the side of the upper end 51A is supported in the upper opening 7b of the spring support hole 7D of the spring support member 7 so as to be capable of freely reciprocating, the contact state between the upper end 51A of the coil spring 51 and the capacitance detection plate 50 can be maintained.

According to the above-described embodiment, by only causing the upper end 51A of the coil spring 51 to abut against the electrostatic-capacitance detection plate 50 and causing the lower end 51B to abut against the electrostatic capacitance detection circuit pattern 6A, the electrostatic-capacitance detection plate 50 and electrostatic capacitance detection circuit pattern 6A can be electrically connected to each other. Therefore, it is not necessary to use a flexible printed circuit board, which leads to high manufacturing costs of components, as in the related art, and the electrostatic capacitance sensor 5 can be easily assembled.

Since the two ends 51A and 51B of the coil spring 51 are respectively caused to abut against the electrostatic-capacitance detection plate 50, which is attached to the rear surface of the operation knob 3, and the electrostatic capacitance detection circuit pattern 6A, which is formed on the circuit board 6, such that the operation knob 3 is constantly raised upward by the urging force of the coil spring 51, rattling will not be generated between the operation knob 3 and the case 2, and the operation knob 3 can be operated so as to be inclined accurately.

The present invention is not limited to the above-described embodiment. In other words, those skilled in the art may make various changes and alternations to the components according to the above-described embodiment and may perform combinations and sub-combinations of the components according to the above-described embodiment within the technical scope of the present invention or within a range equivalent to the technical scope of the present invention.

In the above-described embodiment, although the four-direction push switch 4 is used as a switch that switches the input modes, the present invention is not limited to the four-direction push switch 4 and can be applied to a slide switch, a rotary switch, and the like each of which is provided with a function of switching an input mode.

In the above-described embodiment, the portion of the coil spring 51 on the side of the upper end 51A and the portion of the coil spring 51 on the side of the lower end 51B are closely wound, and the intermediate portion 51C is sparsely wound. However, in the present invention, at least one of the two end portions of the coil spring 51, which is held by the spring support member 7, may be closely wound.

The present invention can be applied to an input apparatus provided with an electrostatic capacitance sensor.

## Claims

1. An input apparatus (1) comprising:
a switch (4) that switches an input mode as a result of an operation knob (3), which is attached to a case (2), being operated; and
an electrostatic capacitance sensor (5) that detects an operating body coming close to or being in contact with the operation knob,
wherein the electrostatic capacitance sensor includes
an electrostatic-capacitance detection plate (50) attached to a rear surface of the operation knob, the electrostatic-capacitance detection plate being made of a metal,
a circuit board (6) disposed in such a manner as to face the operation knob with a predetermined distance between the circuit board and the operation knob,
an electrostatic capacitance detection circuit pattern (6A) formed on the circuit board, and
a compression-coil spring (51) having a first end, which is caused to abut against the electrostatic-capacitance detection plate by an urging force in such a manner as to be electrically connected to the electrostatic-capacitance detection plate, and a second end, which is caused to abut against the electrostatic capacitance detection circuit pattern by an urging force so as to be electrically connected to the electrostatic capacitance detection circuit pattern, wherein
a spring support member (7) is provided on a side on which the rear surface of the operation knob is present,
a spring support hole (7D) into which the compression-coil spring is inserted is formed in the spring support member in such a manner as to extend through the spring support member, **characterised in that**
the spring support hole is formed such that a width of the spring support hole on an entry side from which the compression-coil spring is inserted is larger than the width of the spring support hole on an exit side from which the compression-coil spring is exited, and that
a portion of the compression-coil spring on the first end side is supported in such a manner as to be capable of freely reciprocating on the exit side of the spring support hole.

2. The input apparatus according to Claim 1
wherein the spring support hole is tapered such that the width of the spring support hole gradually decreases from the entry side, from which the compression-coil spring is inserted, toward the exit side, from which the compression-coil spring is exited.

3. The input apparatus according to Claim 1 or 2,
wherein at least a portion of the compression-coil spring on the first end side, which is supported by the spring support member, is closely wound.

4. The input apparatus according to any one of Claims 1 to 3,
wherein the switch is a four-direction push switch attached to the case such that the operation knob is capable of being freely inclined in four directions, which are perpendicular to one another, and
wherein the first end of the compression-coil spring is caused to abut against the electrostatic-capacitance detection plate by an urging force and supported by the spring support member in such a manner as to be located at the center of inclination of the operation knob.

## Patentansprüche

1. Eingabevorrichtung (1), aufweisend:
einen Schalter (4), der einen Eingabemodus infolge einer Betätigung eines an einem Gehäuse (2) angebrachten Betätigungsknopfs (3) schaltet; und
einen elektrostatischen Kapazitätssensor (5), der einen Betätigungskörper erfasst, der sich dem Betätigungsknopf nähert oder mit diesem in Kontakt steht,
wobei der elektrostatische Kapazitätssensor aufweist:
eine elektrostatische Kapazitätserfassungs-Platte (50), die an einer rückwärtigen Fläche des Betätigungsknopfs angebracht ist, wobei die elektrostatische Kapazitätserfassungs-Platte aus Metall besteht,
eine Leiterplatte (6), die derart angeordnet ist, dass sie dem Betätigungsknopf mit einem vorbestimmten Abstand zwischen der Leiterplatte und dem Betätigungsknopf zugewandt ist,
ein elektrostatisches Kapazitätserfassungs-Schaltungsmuster (6A), das auf der Leiterplatte gebildet ist,
und eine Kompressionsschraubenfeder (51) mit einem ersten Ende, das durch eine Drückkraft an der elektrostatischen Kapazitätserfassungs-Platte derart in Anlage gebracht ist, dass es mit der elektrostatischen Kapazitätserfassungs-Platte elektrisch verbunden ist, und mit einem zweiten Ende, das durch eine Drückkraft an dem elektrostatischen Kapazitätserfassungs-Schaltungsmuster derart in Anlage gebracht ist, dass es mit dem elektrostatischen Kapazitätserfassungs-Schaltungsmuster elektrisch verbunden ist,
wobei ein Federabstützelement (7) auf einer Seite vorgesehen ist, auf der sich die rückwärtige Fläche des Betätigungsknopfes befindet,
wobei eine Federabstützöffnung (7D), in die Kompressionsschraubenfeder eingesetzt ist, in dem Federabstützelement derart ausgebildet ist, dass sie sich durch das Federabstützelement hindurch erstreckt,
**dadurch gekennzeichnet,**
**dass** die Federabstützöffnung derart ausgebildet ist, dass eine Breite der Federabstützöffnung auf einer Eintrittsseite, von der aus die Kompressions - schraubenfeder eingesetzt wird, größer ist als die Breite der Federabstütz - öffnung auf einer Austrittsseite, von der die Kompressionsschraubenfeder austritt,
und **dass** ein Bereich der Kompressionsschraubenfeder auf der ersten Endseite derart abgestützt ist, dass er sich auf der Austrittsseite der Federabstützöffnung frei hin und her bewegen kann.

2. Eingabevorrichtung nach Anspruch 1,
wobei die Federabstützöffnung derart verjüngt ausgebildet ist, dass die Breite der Federabstützöffnung von der Eintrittsseite, von der die Kompressionsschraubenfeder eingesetzt wird, zu der Austrittsseite, von der die Kompressionsschraubenfeder austritt, allmählich abnimmt.

3. Eingabevorrichtung nach Anspruch 1 oder 2,
wobei zumindest ein Bereich der Kompressionsschraubenfeder auf der ersten Endseite, die von dem Federabstützelement abgestützt ist, eng gewickelt ist.

4. Eingabevorrichtung nach einem der Ansprüche 1 bis 3,
wobei der Schalter ein Vierrichtungs-Drückschalter ist, der an dem Gehäuse derart angebracht ist, dass der Betätigungsknopf frei in vier Richtungen geneigt werden kann, die zueinander senkrecht sind, und
wobei das erste Ende der Kompressionsschraubenfeder durch eine Drücckraft an der elektrostatischen Kapazitätserfassungs-Platte in Anlage gebracht ist und von dem Federabstützelement derart abgestützt ist, dass es sich an dem Neigungszentrum des Betätigungsknopfes befindet.

## Revendications

1. Appareil d'entrée (1) comprenant :
un commutateur (4) qui enclenche un mode d'entrée suite à l'actionnement d'un bouton de commande (3), qui est fixé à un boîtier (2) ; et
un capteur de capacitance électrostatique (5) qui détecte un corps de commande se rapprochant ou étant en contact avec le bouton de commande,
dans lequel le capteur de capacitance électrostatique comprend
une plaque de détection de la capacitance électrostatique (50) fixée à la face arrière du bouton de commande, la plaque de détection de la capacitance électrostatique étant en métal,
un circuit imprimé (6) disposé de manière à faire face au bouton de commande, la distance entre le circuit imprimé et le bouton de commande étant prédéterminée,
un tracé de circuit de détection de la capacitance électrostatique (6A) formé sur le circuit imprimé, et
un ressort hélicoïdal de compression (51) dont une première extrémité doit venir buter contre la plaque de détection de la capacitance électrostatique par l'action d'une force de sollicitation de manière à être connecté électriquement à la plaque de détection de la capacitance électrostatique, et dont une deuxième extrémité doit venir buter contre le tracé du circuit de détection de la capacitance électrostatique par l'action d'une force de sollicitation de manière à être connecté électriquement au tracé du circuit de détection de la capacitance électrostatique,
dans lequel
un élément de support du ressort (7) est situé sur un côté sur lequel se trouve la face arrière du bouton de commande,
un orifice de support du ressort (7D), dans lequel le ressort hélicoïdal de compression est inséré, est formé dans l'élément de support du ressort de manière à s'étendre à travers l'élément de support du ressort,
**caractérisé en ce que**
l'orifice de support du ressort est formé de telle sorte qu'une largeur de l'orifice de support du ressort sur un côté entrée où le ressort hélicoïdal de compression est inséré est plus grande que la largeur de l'orifice de support du ressort sur un côté sortie par où le ressort hélicoïdal de compression sort,
et **en ce que**
une partie du ressort hélicoïdal de compression du côté de la première extrémité est supporté de manière à se déplacer librement en va-et-vient sur le côté sortie de l'orifice de support du ressort.

2. L'appareil d'entrée selon la revendication 1,
dans lequel l'orifice de support du ressort est conique, de sorte que la largeur de l'orifice de support du ressort diminue graduellement depuis le côté entrée, par lequel le ressort hélicoïdal de compression est inséré, jusqu'au côté sortie, par où le ressort hélicoïdal de compression sort.

3. L'appareil d'entrée selon la revendication 1 ou 2,
dans lequel au moins une partie du ressort hélicoïdal de compression du côté de la première extrémité, qui est supportée par l'élément de support du ressort, est étroitement enroulée.

4. L'appareil d'entrée selon l'une quelconque des revendications 1 à 3,
dans lequel le commutateur est un bouton-poussoir à quatre directions fixé au boîtier de telle sorte que le bouton de commande peut être librement incliné dans quatre directions, qui sont perpendiculaires l'une par rapport à l'autre, et
dans lequel la première extrémité du ressort hélicoïdal de compression doit venir buter contre la plaque de détection de la capacitance électrostatique par l'action d'une force de sollicitation et est supportée par l'élément de support du ressort de manière à être située au centre d'inclinaison du bouton de commande.
